# EUROPÄISCHE PATENTANMELDUNG

(11) **EP 2 138 856 A2**
(43) Veröffentlichungstag der Anmeldung: **30.12.2009**
(21) Anmeldenummer: 08164807.3
(22) Anmeldetag: 22.09.2008
(51) Int. Cl.: G01R 31/312, G09G 3/00

(54) **Vorrichtung und Verfahren zur berührungslosen Ankontaktierung von leitfähigen Strukturen, insbesondere von Dünnschicht-Transistor-Flüssigkristallanzeigen**

(30) Priorität: 27.06.2008 DE 102008030545
(71) Anmelder: Siemens Aktiengesellschaft, 80333 München (DE)
(72) Erfinder: Klausmann, Hagen, 91336 Heroldsbach (DE); Kragler, Karl, 85622 Weissenfeld (DE)

(57) **Zusammenfassung**

Die vorliegende Erfindung betrifft eine Vorrichtung und ein Verfahren zur Erzeugung eines, für eine Inspektion von mindestens einer auf einem Substrat (1) ausgebildeten leitfähigen Struktur (3) erforderlichen, elektrischen Feldes in dem Substrat (1). Die Erfindung zeichnet sich dadurch aus, dass das Feld durch mechanisch kontaktlose Anregungen der leitfähigen Struktur (3) erzeugt ist bzw. wird. Auf diese Weise kann eine Inspektion ebenso bei Substraten (1) ausgeführt werden, bei denen eine leitfähige Struktur (3) nicht herkömmlich mechanisch ankontaktierbar ist. Erfindungsgemäß ist eine Inspektion bei allen Herstellungsverfahrensstadien von derartigen Substraten (3) ausführbar.

## Beschreibung

Die vorliegende Erfindung betrifft eine Vorrichtung, eine Verwendung einer derartigen Vorrichtung und ein Verfahren zur Erzeugung eines, für eine Inspektion von mindestens einer auf einem Substrat ausgebildeten leitfähigen Struktur erforderlichen, elektrischen Feldes in dem Substrat.

In dem Bereich von Inspektionen, insbesondere von LCD-(Flüssigkristallanzeige-) Flachbildschirmsubstraten, kann beispielsweise mit Hilfe eines herkömmlichen Verfahrens zur Inspektion einer Leiterbahnstruktur die Güte und Qualität eines Dünnschichttransistor- (Thin Film Transistor-) Matrix-LCD-Bildschirmsubstrats inspiziert werden.

Die DE 10 2005 022 884 A1 offenbart ein derartiges Verfahren zur Inspektion einer Leiterbahnstruktur. Es wird ein Verfahren zur kontaktlosen Inspektion von einer auf einem flächigen Träger ausgebildeten Leiterbahnstruktur bereitgestellt, bei dem mittels einer Positioniereinrichtung eine Elektrode relativ zu der Leiterbahnstruktur in einem vorbestimmten Abstand positioniert wird und zwischen der Elektrode und der Leiterbahnstruktur eine elektrische Spannung angelegt wird. Die Elektrode wird in einer Ebene parallel zu dem Träger bewegt, wobei zumindest an ausgewählten Positionen ein Stromfluss durch eine mit der Elektrode verbundene elektrische Leitung gemessen wird. Aus der Stärke des Stromflusses wird der lokale Spannungszustand in einem Teilbereich der Leiterbahnstruktur detektiert. Dieser Spannungszustand kann zur Bestimmung der Qualität der Leiterbahnstruktur verwendet werden. Damit können durch geometrische Veränderungen der Leiterbahnstruktur erzeugte Defekte wie Kurzschlüsse, Einschnürungen oder Leitungsbrüche erkannt werden. Es werden Sensorelektroden in geringem Abstand über die Oberfläche des Substrates geführt und die Stärke des elektrischen Feldes mittels kapazitiver Kopplung gemessen.

Um das zur Inspektion nötige elektrische Feld, insbesondere im LCD-Bildschirmsubstrat zu erzeugen, müssen die Leiterbahnen des Substrates mit einem elektrischen Signal angeregt werden. In fertig prozessierten Substraten wird dies durch das mechanische Ankontaktieren dafür vorgesehener Zuleitungen, den sogenannten Pads, erreicht. Dies kann beispielsweise über Spitzen, den sogenannten Probes bzw. Flexkontakter, ausgeführt sein. Dies erfolgt beispielsweise in einer Vorrichtung und mit einem Verfahren gemäß der DE 10 2006 054 089.1, die ein Sensorelement, eine Vorrichtung und ein Verfahren zur Inspektion einer Leiterbahnstruktur offenbart.

Die DE 10 2006 054 089.1 offenbart ein Sensorelement zur Inspektion von einer an einem Flächenträger ausgebildeten Leiterbahnstruktur. Das Sensorelement umfasst dabei ein Substrat, welches mechanisch derart strukturiert ist, dass es einen erhabenen oberen Bereich und einen vertieften unteren Bereich aufweist, wobei der plane obere Bereich und der vertiefte untere Bereich durch einen bevorzugten stufenförmigen Übergangsbereich miteinander verbunden sind. Das Sensorelement umfasst ferner eine Mehrzahl von Sensorelektroden, die an dem planen oberen Bereich ausgebildet sind, und eine Mehrzahl von Verbindungsleitungen zum elektrischen Kontaktieren der Mehrzahl von Sensorelektroden. Dabei ist jeder Sensorelektrode eine Verbindungsleitung zugeordnet, die sich von der jeweiligen Sensorelektrode bis hin zu dem vertieften unteren Bereich erstreckt. Es wird ferner eine Vorrichtung sowie ein Verfahren zur Inspektion einer Leiterbahnstruktur beschrieben. Außerdem wird ein Herstellverfahren für ein oben genanntes Sensorelement angegeben.

Dieser Stand der Technik weist den Nachteil auf, dass bei Prozessabschnitten, in denen das Substrat noch über keine Möglichkeit zum Kontaktieren der Leiterbahnen verfügt, eine Inspektion ausgeschlossen ist.

Es ist Aufgabe der vorliegenden Erfindung eine Vorrichtung, und ein Verfahren zur Erzeugung eines, für eine Inspektion von mindestens einer auf einem Substrat ausgebildeten leitfähigen Struktur erforderlichen, elektrischen Feldes in dem Substrat derart bereitzustellen, dass eine Inspektion ebenso bei Substraten ausgeführt werden kann, bei denen die leitfähige Struktur nicht herkömmlich mechanisch ankontaktierbar ist. Insbesondere soll eine Inspektion bei allen Herstellungsverfahrensstadien von derartigen Substraten ausführbar sein. Es soll eine Erweiterung einer herkömmlichen Vorrichtung und eines herkömmlichen Verfahrens vorgeschlagen werden, mit der die Inspektion ebenso im Fall von teilprozessierten Substraten, ausführbar ist. Die Inspektion von voll prozessierten Substraten soll ebenfalls ausführbar sein.

Die Aufgabe wird durch eine Vorrichtung gemäß dem Hauptanspruch, ein Verfahren gemäß dem Nebenanspruch und Verwendungen gemäß weiteren Nebenansprüchen gelöst.

Die Inspektion von Substraten in allen Herstellungsverfahrensstadien ist durch mechanisch kontaktloses Anregen von leitfähigen Strukturen, insbesondere Leiterbahnen, ausführbar.

Durch eine erfindungsgemäße Vorrichtung beziehungsweise ein erfindungsgemäßes Verfahren beziehungsweise einer erfindungsgemäßen Verwendung ergeben sich folgende Vorteile:
a) Ein herkömmlicher aufwändiger und substratspezifischer Kontaktierungsmechanismus entfällt vollständig. Dies bewirkt einerseits für einen Kunden ein erhebliches Einsparungspotential, da Produktwechsel ohne mechanischen Umbau oder Abänderung einer Substratankontaktierung ausführbar sind. Ebenso entfallen die Wartung und die Lagerung teuerer Kontaktiervorrichtungen. Des Weiteren ergeben sich Verbesserungen hinsichtlich der Herstellungskosten.
b) Es ist nicht mehr erforderlich, die Kontaktierungsflächen auf einer Vorderseite zu berühren. Dies bewirkt eine wirksame Verringerung einer möglichen Kontamination oder Zerstörung von Kontaktflächen. Dies ist besonders vorteilhaft, da diese Kontaktflächen später beim Zusammenbau, insbesondere eines LCD-Bildschirms in der Regel verwendet werden.
c) Es wird eine große Flexibilität beim Layout bereitgestellt, da Test- oder Kurzschlussstrukturen nicht notwendigerweise bereitgestellt werden müssen. Auf diese Weise kann eine Ausnutzung einer Substratfläche optimiert werden.

Weitere vorteilhafte Ausgestaltungen werden in Verbindung mit den Unteransprüchen beansprucht.

Gemäß einer vorteilhaften Ausgestaltung ist/wird ein elektrisches Signal in die leitfähige Struktur eingekoppelt. Auf diese Weise wird das Feld erzeugt.

Gemäß einer weiteren vorteilhaften Ausgestaltung ist/wird das elektrische Signal in die leitfähige Struktur kapazitiv eingekoppelt.

Gemäß einer weiteren vorteilhaften Ausgestaltung ist/wird das elektrische Signal in die leitfähige Struktur über eine große Fläche eingekoppelt.

Gemäß einer weiteren vorteilhaften Ausgestaltung ist/wird die große Fläche von einem Substrathalter oder einer separaten flächigen Elektrode bereitgestellt. Der Substrathalter kann die separate flächige Elektrode beinhalten, an die das elektrische Signal gelegt wird. Der Substrathalter kann dann elektrisch neutral sein. Auf diese Weise wird die Generierung von Störsignalen verringert.

Gemäß einer weiteren vorteilhaften Ausgestaltung ist/wird der Substrathalter oder die separate flächige Elektrode unterhalb des Substrats positioniert und das elektrische Signal durch das Substrat hindurch eingekoppelt.

Gemäß einer weiteren vorteilhaften Ausgestaltung ist das Substrat ein Bildschirmglassubstrat einer Flüssigkristallanzeige (LCD, Liquid Crystal Display) und leitfähige Strukturen sind Leiterbahnen von TFT-Elektroden (Thin Film Transistor-Elektroden). Da es nicht mehr erforderlich ist, Kontaktierungsflächen auf einer Vorderseite zu berühren, wird eine mögliche Kontamination oder Zerstörung von Kontaktflächen vermieden. Kontaktflächen werden später beim Zusammenbau eines LCD-Bildschirms in der Regel verwendet.

Gemäß einer weiteren vorteilhaften Ausgestaltung sind leitfähige Strukturen nicht elektrisch zusammenhängend und/oder alternativ dielektrisch. Leiterbahnstrukturen auf einer Oberfläche müssen nicht mehr elektrisch zusammenhängend sein, d.h. jede beliebige Struktur, und zwar leitfähig oder dielektrisch, kann ankontaktiert und sichtbar gemacht werden. Auf diese Weise kann prinzipiell nach jedem Prozess-Schritt inspiziert werden. Ein Kunde erhält mehr Flexibilität und kann seine Prozesse besser kontrollieren. Dies ist ein weiterer Vorteil der vorliegenden Erfindung.

Gemäß einer weiteren vorteilhaften Ausgestaltung können eine erfindungsgemäße Vorrichtung bzw. ein erfindungsgemäßes Verfahren bei einer kontaktlosen Inspektion von leitfähigen Strukturen verwendet werden, wobei bei einem derartigen Verfahren mindestens eine Sensorelektrode in kleinem Abstand über die Oberfläche des Substrats geführt und die Stärke des elektrischen Feldes mittels kapazitiver Kopplung gemessen wird. Die erfindungsgemäße Vorrichtung bzw. das erfindungsgemäße Verfahren kann ebenso in einer derartigen Vorrichtung zur kontaktlosen Inspektion von leitfähigen Strukturen verwendet werden.

Die vorliegende Erfindung wird anhand von Ausführungsbeispielen in Verbindung mit den Figuren näher beschrieben. Es zeigen:
- Figur 1: eine Darstellung eines erfindungsgemäßen Ausführungsbeispiels;
- Figur 2: einen herkömmlichen Versuchsaufbau und ei nen Versuchsaufbau gemäß der vorliegenden Erfindung;
- Figur 3: zeigt Messergebnisse gemäß dem Stand der Technik und gemäß der vorliegenden Erfin dung.

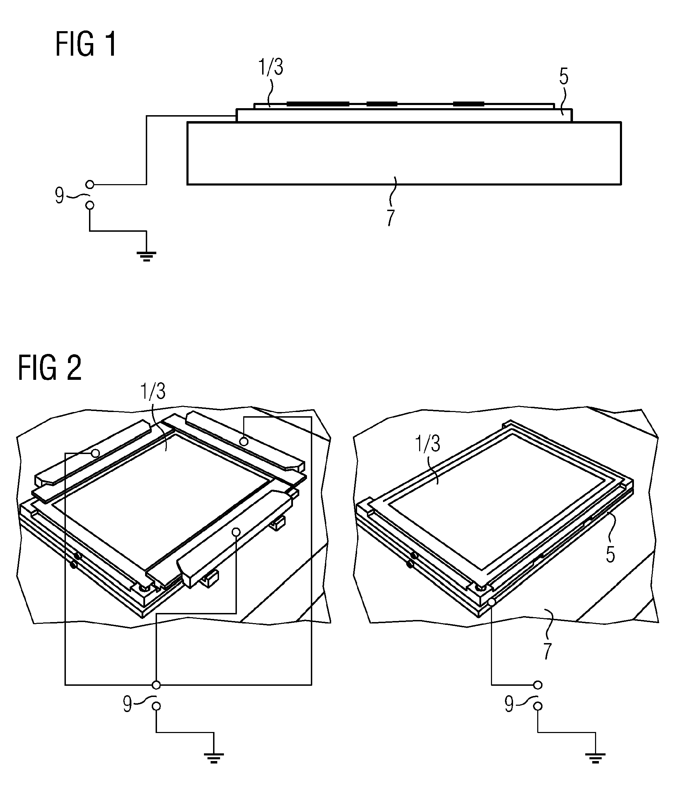

- Figur 1, 2 und 3: zeigen ein Ausführungsbeispiel für einen 64-Kanal-Sensor.

Figur 1 zeigt eine Darstellung eines Ausführungsbeispiels einer erfindungsgemäßen kontaktlosen Anregung. Eine kontaktlose Anregung von leitfähigen Strukturen 3, insbesondere Leiterbahnen, wird dadurch bereit gestellt, dass ein elektrisches Signal 9 mit Hilfe eines unterhalb eines Substrats 1 liegenden Substrathalters 5 beziehungsweise Chucks in die Leiterbahnen, insbesondere eines TFT (Dünnschichttransistor)-Glassubstrats 1 eingespeist wird. Dies bewirkt, dass einzelne Pads oder Kontaktierungsflächen nicht berührt werden müssen. Die Einkopplung des elektrischen Signals 9 in die leitfähigen Strukturen 3 des Substrats 1 auf der Oberseite wird kapazitiv durch das Glassubstrat 1 hindurch bereit gestellt. Der Substrathalter 5 ist auf einer elektrisch vom Substrathalter 5 getrennten Basis 7 angeordnet. Gemäß dem Ausführungsbeispiel gemäß Figur 1 wird das Signal 9, das insbesondere ein Spannungssignal zur Anregung ist, direkt an den Substrathalter 5 gelegt.

Figur 2 stellt einen Versuchsaufbau gemäß dem Stand der Technik auf der linken Seite und auf der rechten Seite einen Versuchsaufbau gemäß der vorliegenden Erfindung dar. Links ist ein LCD-Substrat 1 mit einer aufwändigen elektrischen Kontaktiereinheit dargestellt. Rechts ist ein LCD-Substrat 1 ohne eine herkömmliche elektrische Kontaktiereinheit dargestellt. Die rechte Darstellung stellt eine erfindungsgemäße Vorrichtung dar beziehungsweise veranschaulicht ein erfindungsgemäßes Verfahren. Die linke Darstellung zeigt ein LCD-Panel auf einem Substrathalter 5 mit einer herkömmlichen Kontaktiereinheit. Die Darstellung rechts zeigt ein LCD-Panel 1 ohne eine herkömmliche Kontaktiereinheit, mit einer kapazitiven Ankontaktierung. Bezugszeichen 9 bezeichnet ein elektrisches Signal, insbesondere ein Spannungssignal, zur Anregung. Prinzipiell kann ein Substrathalter 5 ebenso eine separate flächige Elektrode aufweisen, an die dann ein Spannungssignal 9 zur Anregung gelegt werden kann. Der Substrathalter 5 selbst kann dann elektrisch neutral sein. Auf diese Weise kann Generierung von Störsignalen verringert werden. Der Substrathalter 5 ist auf einer Basis 7 angeordnet. Das Substrat 1 weist leitfähige Strukturen 3, die zu inspizieren sind, auf.

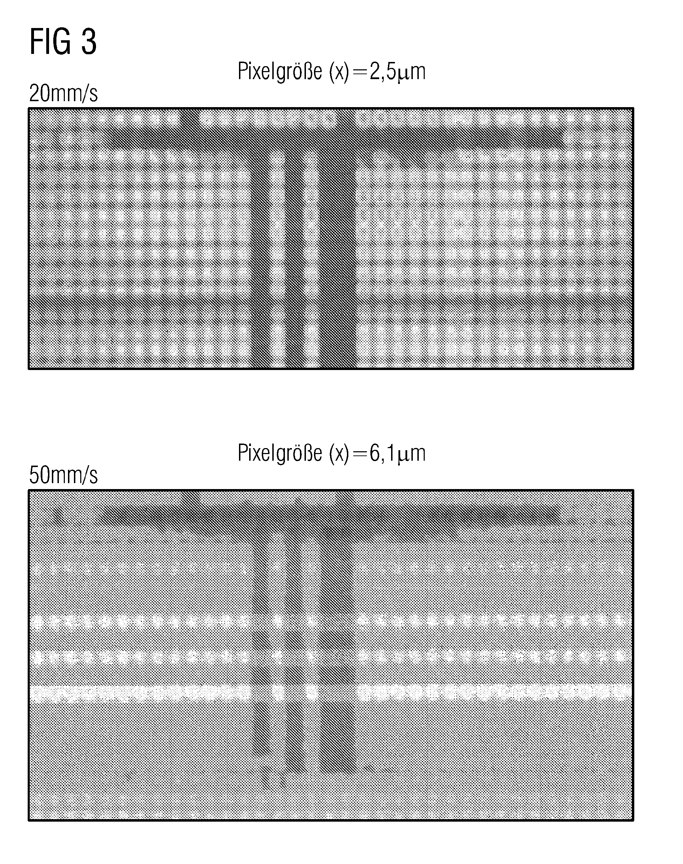

Figur 3 zeigt die Messergebnisse gemäß dem Stand der Technik und gemäß der vorliegenden Erfindung. Die obere Darstellung in Figur 3 zeigt eine Fehlerstruktur eines Substrats mit mechanischer Ankontaktierung. Im Fall der mechanischen, selektiven, mechanischen Kontaktierung sind die fehlerhaften Stellen deutlich als schwarze Pixel zu erkennen. Die untere Darstellung zeigt eine Fehlerstruktur mit kapazitiver Ankontaktierung. Die untere Darstellung von Figur 3 zeigt dieselbe Fehlerstruktur mit kapazitiver, d.h. berührungsloser, Ankontaktierung. Das Fehlerbild mit kapazitiver Ankontaktierung ist mit zwar geringerem Detailreichtum, aber immer noch deutlich zu erkennen. Ein horizontales Helligkeitsvariieren einzelner Zeilen ist durch eine nicht erfolgte Empfindlichkeits-Korrektur des verwendeten Mehrkanalsensors verursacht.

## Patentansprüche

1. Vorrichtung zur Erzeugung eines, für eine Inspektion von mindestens einer auf einem Substrat (1) ausgebildeten leitfähigen Struktur (3) erforderlichen, elektrischen Feldes in dem Substrat (1), **dadurch gekennzeichnet, dass**
das Feld durch mechanisch kontaktlose Anregung der leitfähigen Struktur (3) erzeugt ist.

2. Vorrichtung nach Anspruch 1,
**dadurch gekennzeichnet, dass**
ein elektrisches Signal (9) in die leitfähige Struktur (3) eingekoppelt ist.

3. Vorrichtung nach Anspruch 2,
**dadurch gekennzeichnet, dass**
das elektrische Signal (9) in die leitfähige Struktur (3) kapazitiv eingekoppelt ist.

4. Vorrichtung nach Anspruch 2 oder 3,
**dadurch gekennzeichnet, dass**
das elektrische Signal (9) in die leitfähige Struktur (3) über eine große Fläche eingekoppelt ist.

5. Vorrichtung nach Anspruch 4,
**dadurch gekennzeichnet, dass**
die große Fläche von einem Substrathalter (5) oder einer separaten flächigen Elektrode bereitgestellt ist.

6. Vorrichtung nach Anspruch 5,
**dadurch gekennzeichnet, dass**
der Substrathalter (5) oder die separate Elektrode unterhalb des Substrats (1), insbesondere auf einer elektrisch vom Substrathalter (5) oder von der Elektrode getrennten Basis (7), positioniert ist und das elektrische Signal (9) durch das Substrat (1) hindurch eingekoppelt ist.

7. Vorrichtung nach einem der vorangehenden Ansprüche 1 bis 6, **dadurch gekennzeichnet, dass**
das Substrat (1) ein Bildschirmglassubstrat einer Flüssigkristallanzeige (LCD, Liquid Crystal Display) ist und leitfähige Strukturen (3) Leiterbahnen von TFT-Elektroden (Thin Film Transistor-Elektroden) sind.

8. Vorrichtung nach einem der vorangehenden Ansprüche 1 bis 7,
**dadurch gekennzeichnet, dass**
leitfähige Strukturen (3) nicht elektrisch zusammenhängend sind oder alternativ dielektrisch sein können.

9. Verwendung einer Vorrichtung nach einem der vorangehenden Ansprüche 1 bis 8, für ein Verfahren zur kontaktlosen Inspektion der leitfähigen Strukturen (3), wobei bei diesem Verfahren mindestens eine Sensorelektrode in kleinem Abstand über die Oberfläche des Substrates (1) geführt und die Stärke des elektrischen Feldes mittels kapazitiver Kopplung gemessen wird.

10. Verwendung einer Vorrichtung nach einem der vorangehenden Ansprüche 1 bis 8, in einer Vorrichtung zur kontaktlosen Inspektion der leitfähigen Strukturen (3), wobei diese Vorrichtung mindestens eine Sensorelektrode in kleinem Abstand über die Oberfläche des Substrates (1) führt und die Stärke des elektrischen Feldes mittels kapazitiver Kopplung misst.

11. Verfahren zur Erzeugung eines, für eine Inspektion von mindestens einer auf einem Substrat (1) ausgebildeten leitfähigen Struktur (3) erforderlichen, elektrischen Feldes in dem Substrat (1), **dadurch gekennzeichnet, dass**
das Feld durch mechanisch kontaktlose Anregung der leitfähigen Struktur (3) erzeugt wird.

12. Verfahren nach Anspruch 11,
**dadurch gekennzeichnet, dass**
ein elektrisches Signal (9) in die leitfähige Struktur (3) eingekoppelt wird.

13. Verfahren nach Anspruch 12,
**dadurch gekennzeichnet, dass**
das elektrische Signal (9) in die leitfähige Struktur (3) kapazitiv eingekoppelt wird1.

14. Verfahren nach Anspruch 12 oder 13,
**dadurch gekennzeichnet, dass**
das elektrische Signal (9) in die leitfähige Struktur (3) über eine große Fläche eingekoppelt wird.

15. Verfahren nach Anspruch 14,
**dadurch gekennzeichnet, dass**
die große Fläche von einem Substrathalter (5) oder einer separaten flächigen Elektrode bereitgestellt wird.

16. Verfahren nach Anspruch 15,
**dadurch gekennzeichnet, dass**
der Substrathalter (5) oder die separate Elektrode unterhalb des Substrats (1), insbesondere auf einer elektrisch vom Substrathalter (5) oder von der Elektrode getrennten Basis (7), positioniert wird und das elektrische Signal durch das Substrat (1) hindurch eingekoppelt wird.

17. Verfahren nach einem der vorangehenden Ansprüche 11 bis
16, **dadurch gekennzeichnet, dass**
das Substrat (1) ein Bildschirmglassubstrat einer Flüssigkristallanzeige (LCD, Liquid Crystal Display) ist und leitfähige Strukturen (3) Leiterbahnen von TFT-Elektroden (Thin Film Transistor-Elektroden) sind.

18. Verfahren nach einem der vorangehenden Ansprüche 11 bis 17,
**dadurch gekennzeichnet, dass**
leitfähige Strukturen (3) nicht elektrisch zusammenhängend sind oder alternativ dielektrisch sind.

19. Verwendung eines Verfahrens nach einem der vorangehenden Ansprüche 11 bis 18, für ein Verfahren zur kontaktlosen Inspektion der leitfähigen Strukturen (3), wobei bei diesem Verfahren mindestens eine Sensorelektrode in kleinem Abstand über die Oberfläche des Substrates (1) geführt und die Stärke des elektrischen Feldes mittels kapazitiver Kopplung gemessen wird.
